# EUROPÄISCHE PATENTANMELDUNG

(11) **EP 1 016 870 A2**
(43) Veröffentlichungstag der Anmeldung: **05.07.2000**
(21) Anmeldenummer: 99811141.3
(22) Anmeldetag: 13.12.1999
(51) Int. Cl.: G01R 31/327

(54) **Prüfkreis für die Prüfung des Abschaltens von kapazitiven Strömen**

(30) Priorität: 29.12.1998 DE 19860580
(71) Anmelder: ABB Hochspannungstechnik AG, 8050 Zürich (CH)
(72) Erfinder: Kutil, Alexander, Dr., 5404 Baden (CH); Jüngermann,Klaus, 79787 Lauchringen (DE)
(74) Vertreter: ABB Patent Attorneys

(57) **Zusammenfassung**

Dieser Prüfkreis (1) ist für die synthetische Prüfung des Abschaltens von kapazitiven Strömen bei einer von der Betriebsfrequenz der Energiequelle für die Speisung des Prüfkreises (1) abweichenden Frequenz vorgesehen. In diesem Prüfkreis (1) ist ein zu prüfendes Schaltgerät in Reihe geschaltet mit mindestens einem Dämpfungswiderstand (7) und mit einer Kondensatorbatterie (13).

Mit diesem Prüfkreis soll eine optimale, der Realität entsprechende synthetische Prüfung des Abschaltens von kapazitiven Strömen geschaffen werden. Dies wird dadurch erreicht, dass parallel zu der Kondensatorbatterie (13) ein zusätzlicher Schaltungszweig bestehend aus einer Reihenschaltung einer Drosselspule (9) mit einem Überspannungsableiter (10) geschaltet wird.

## Beschreibung

### TECHNISCHES GEBIET

Die Erfindung geht aus von einem Prüfkreis für die synthetische Prüfung des Abschaltens von kapazitiven Strömen gemäss dem Oberbegriff des Anspruchs 1.

### STAND DER TECHNIK

Es ist ein Verfahren für die synthetische Prüfung des Abschaltens von kapazitiven Strömen bekannt, welches erlaubt, einen mit der Betriebsfrequenz 50 Hz arbeitenden Generator als Energiequelle für einen Prüfkreis einzusetzen welcher der Prüfung des kapazitiven Abschaltvermögens eines Schaltgerätes mit einer Betriebsfrequenz von 60 Hz dient. Bei diesem bekannten Verfahren wird mittels eines ohmschen Widerstandes eine Verringerung der Phasenverschiebung zwischen der vom Generator gelieferten 50 Hz - Speisespannung und dem kapazitiven Prüfstrom erreicht. Dieser ohmsche Widerstand ist dabei so ausgelegt, dass die Zeit zwischen dem Augenblick der Unterbrechung des kapazitiven Prüfstroms und dem Scheitelwert der wiederkehrenden Spannung 8,33 ms beträgt, diese 8,33 ms entsprechen der halben Periodendauer bei 60 Hz Betriebsfrequenz.

Die Prüfvorschriften nach IEC 56 verlangen, dass der Verlauf der wiederkehrenden Spannung, die nach der Unterbrechung des durch das Schaltgerät fliessenden kapazitiven Stromes zwischen den Kontakten dieses Schaltgerätes ansteht, während der ersten halben Periode steiler oder gleich der geforderten (1-cosωt)-Kurve ist. Mit dem bekannten Prüfkreis ist der erreichbare Anstieg der wiederkehrende Spannung (TRV) stets steiler als gefordert. Diese zu strenge Prüfung hat zur Folge, dass die Schaltgeräte leistungsfähiger ausgebildet sind als der Kunde dies im Grunde verlangt. Diese bessere Abschaltleistung bei kapazitiven Abschaltströmen verteuert das Schaltgerät unnötig und reduziert seine preisliche Konkurrenzfähigkeit.

### DARSTELLUNG DER ERFINDUNG

Die Erfindung, wie sie in den unabhängigen Ansprüchen gekennzeichnet ist, löst die Aufgabe, einen Prüfkreis für die synthetische Prüfung des Abschaltens von kapazitiven Strömen zu schaffen, welcher eine optimale, der Realität entsprechende Prüfung erlaubt.

Die durch die Erfindung erreichten Vorteile sind darin zu sehen, dass realistischer und ohne das Schaltgerät zu hoch zu beanspruchen, geprüft werden kann. Die Entwicklung des Schaltgeräts kann, da schlussendlich kleinere Anforderungen gestellt werden, vorteilhaft verbilligt und beschleunigt werden. Der erfindungsgemässe Prüfkreis kann sehr leicht an beliebige Netzfrequenzen angepasst werden.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Es zeigen:
Fig. 1 eine vereinfachte Darstellung eines erfindungsgemässen Prüfkreises mit geschlossenem Prüfling,
Fig. 2 den Prüfkreis nach Fig. 1 vor dem Erlöschen des Schaltlichtbogens im Prüfling,
Fig. 3 den Prüfkreis nach Fig. 1 nach dem Erlöschen des Schaltlichtbogens im Prüfling, und
Fig. 4 den schematisch dargestellten zeitlichen Verlauf des Abschaltens von kapazitiven Strömen mit dem Prüfkreis nach Fig. 1.

Bei allen Figuren sind gleich wirkende Elemente mit gleichen Bezugszeichen versehen. Alle für das unmittelbare Verständnis der Erfindung nicht erforderlichen Elemente sind nicht dargestellt bzw. nicht beschrieben.

### WEGE ZUR AUSFÜHRUNG DER ERFINDUNG

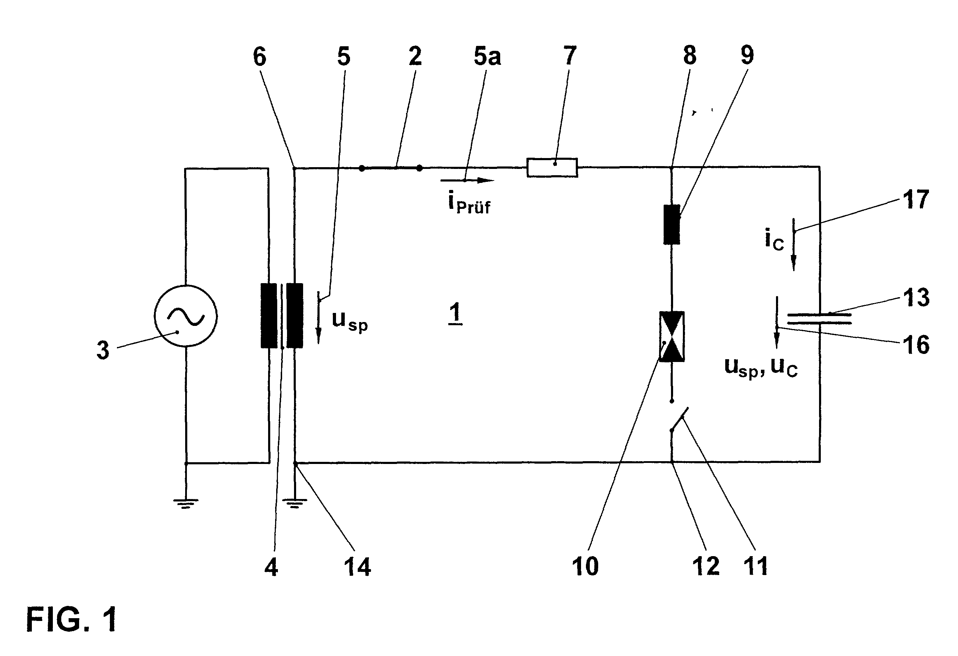

Die Fig. 1 zeigt eine vereinfachte Darstellung eines Prüfkreises 1 für die synthetische Prüfung des kapazitiven Abschaltvermögens von Schaltgeräten. Als Prüfling ist hier beispielsweise ein eingeschaltet dargestellter Leistungsschalter 2 vorgesehen, es können jedoch auch andere Schalter, beispielsweise Trennschalter oder Lastschalter geprüft werden. Von einem Generator 3 wird über einen Transformator 4 elektrische Energie mit einer Frequenz von 50 Hz in den einseitig geerdeten Prüfkreis 1 eingespeist. Auf der Oberspannungsseite des Transformators 4 steht, wie ein Pfeil 5 andeutet, die Speisespannung u_{Sp} zur Verfügung. Die Schutzeinrichtungen für den Generator 3 und den Transformator 4 sind der Einfachheit halber nicht dargestellt, ebenso nicht die stets nötigen Hilfsschalter und Messeinrichtungen. Der Leistungsschalter 2 ist einerseits verbunden mit der hochspannungsseitigen Klemme 6 des Transformators 4 und andererseits mit einem Dämpfungswiderstand 7, dessen andere Seite mit einer Klemme 8 verbunden ist. Die Klemme 8 ist über eine Drosselspule 9, einen Überspannungsableiter 10 und ein im ausgeschalteten Zustand dargestelltes Einschaltgerät 11 mit einer Klemme 12 verbunden, die auf der geerdeten Seite des Prüfkreises 1 liegt. Die Impedanz der Drosselspule 9 weist neben dem induktiven Anteil auch einen nicht zu vernachlässigenden ohmschen Anteil auf. Der Überspannungsableiter 10 ist als Metalloxidableiter ausgeführt. Die Klemme 8 ist ferner über eine Kondensatorbatterie 13 mit der Klemme 12 verbunden. Die Klemme 11 ist zudem mit einer geerdeten Klemme 14 verbunden, die ihrerseits mit dem erdseitigen Ende der Oberspannungswicklung des Transformators 4 verbunden ist.

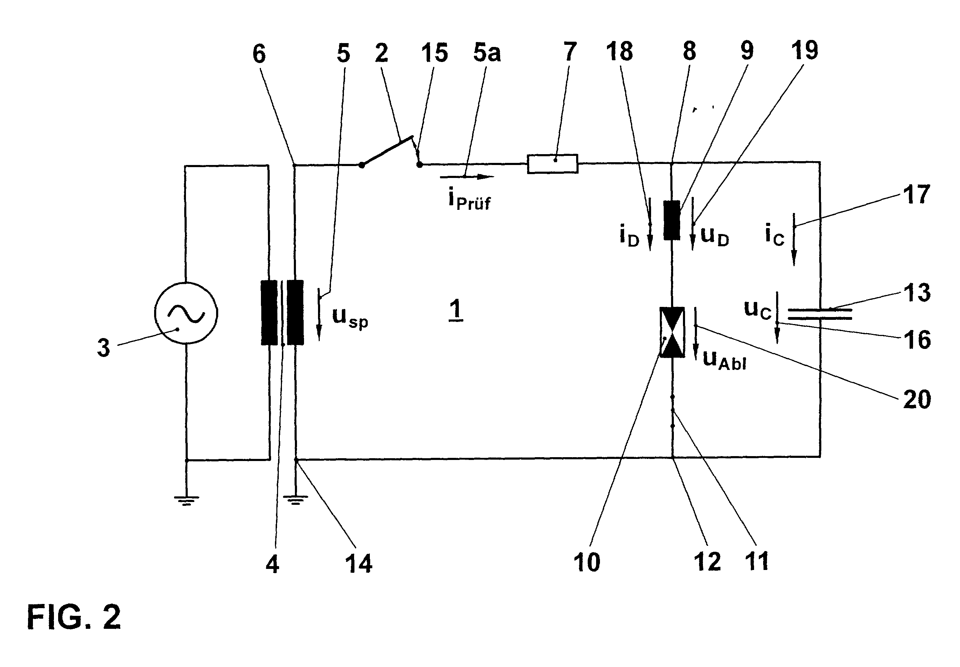

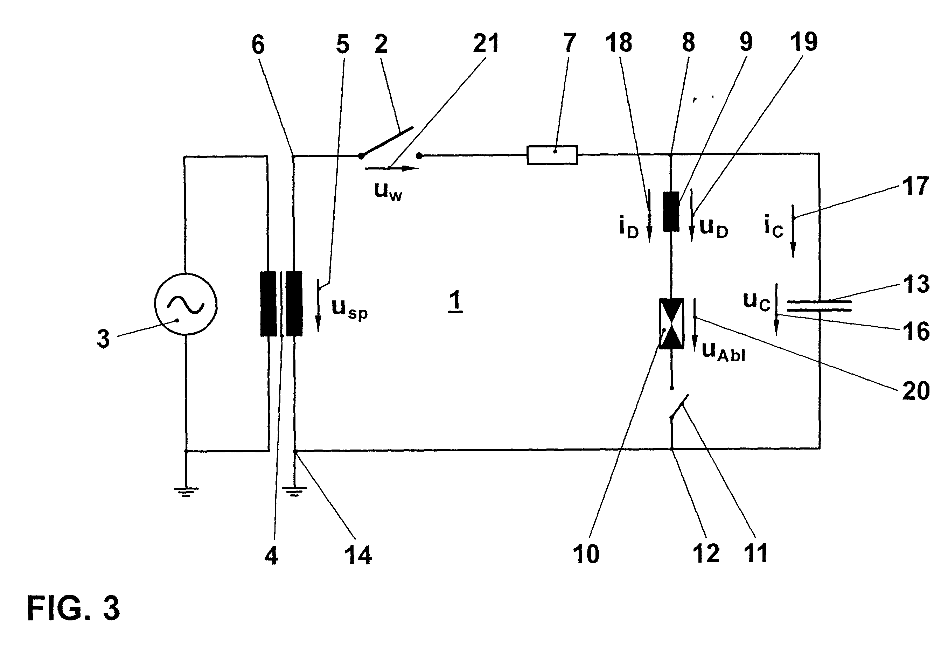

Die Fig. 2 zeigt den Prüfkreis nach Fig. 1 während des Ausschaltvorgangs mit geschlossenem Einschaltgerät 11 und geöffnetem Leistungsschalter 2 in dem, schematisch angedeutet, ein Lichtbogen 15 brennt. Die Fig. 3 zeigt den Prüfkreis nach Fig. 1 unmittelbar nach der erfolgreichen Abschaltung des Leistungsschalters 2.

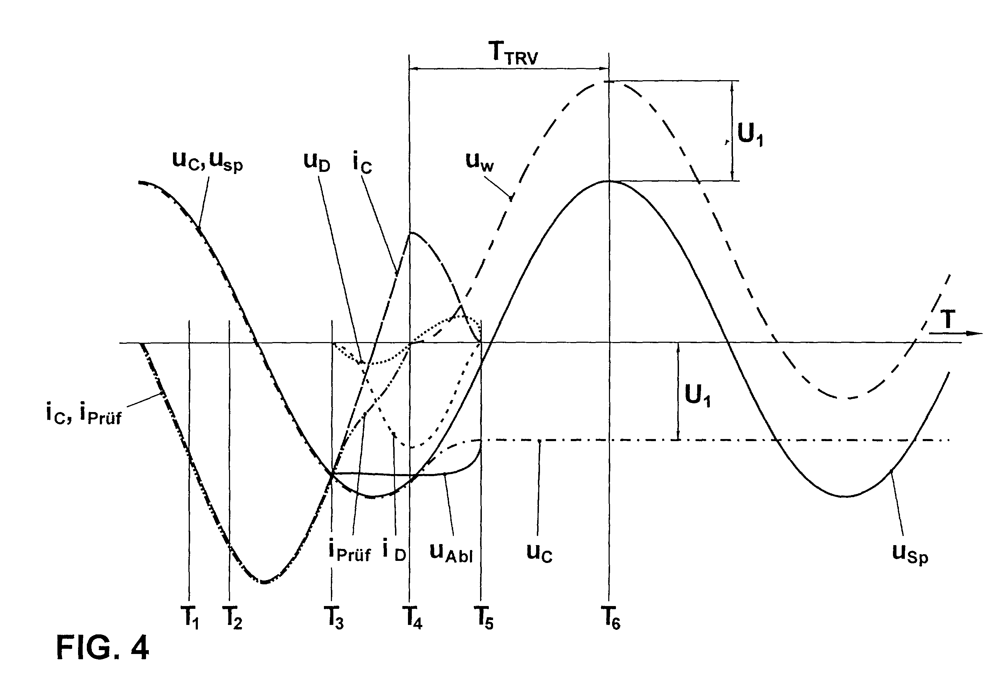

Zur Erläuterung der Wirkungsweise werden die Figuren 1 bis 3 zusammen mit der Fig. 4, welche den schematisch dargestellten zeitlichen Verlauf des Abschaltens von kapazitiven Strömen mit dem Prüfkreis 1 nach Fig. 1 zeigt, näher betrachtet. In der Fig. 4 stellt die Abszisse die Zeitachse T dar, während in Richtung der nicht dargestellten Ordinate Ströme bzw. Spannungen aufgetragen sind. Der Generator 3 liefert die an der Oberspannungsseite des Transformators 4 anstehende, durch den Pfeil 5 angedeutete, 50 Hz-Speisespannung u_{Sp}. Diese Speisespannung u_{Sp} treibt den kapazitiven Prüfstrom i_{Prüf}, wie dies ein Pfeil 5a andeutet, durch den Stromkreis mit der Reihenschaltung von Dämpfungswiderstand 7 und Kondensatorbatterie 13. Wird der Spannungsabfall am Dämpfungswiderstand 7 vernachlässigt, so liegt an der Kondensatorbatterie 13 die durch einen Pfeil 16 angedeutete Spannung u_{c} an, welche zunächst in etwa der Speisespannung u_{Sp} entspricht. Durch die Kondensatorbatterie 13 fliesst der Strom i_{c}, der durch einen Pfeil 17 angedeutet wird. Am linken Rand der Fig. 4 ist der zeitliche Verlauf von Speisespannung u_{Sp}, bzw. Spannung u_{c} und Prüfstrom i_{Prüf}, bzw. Strom i_{c} im eingeschwungenen Zustand dargestellt, der Verlauf der Spannung u_{c} entspricht hier noch in etwa dem Verlauf der Speisespannung u_{Sp} und der Verlauf des Stromes i_{c} entspricht hier noch genau dem Verlauf des Prüfstroms i_{Prüf}.

Im Zeitpunkt T₁, der so gewählt ist, dass die Kontakttrennung des Leistungsschalters 2 erst danach erfolgt, wird das Einschaltgerät 11 geschlossen. Der Zweig des Prüfkreises 1, der aus der Reihenschaltung der Drosselspule 9 und dem Überspannungsableiter 10 besteht, ist damit zugeschaltet, er wird jedoch nicht sofort von Strom durchflossen, da die Ansprechspannung des Überspannungsableiters 10 noch nicht erreicht wurde. Im Zeitpunkt T₂ findet beim Leistungsschalter 2 die Kontakttrennung statt und ein Lichtbogen 15 bildet sich aus, wie in der Fig. 2 dargestellt. Zeitlich danach erreicht im Zeitpunkt T₃ die Speisespannung u_{Sp}, bzw. Spannung u_{c} den Wert der Ansprechspannung des Überspannungsableiters 10 und der Überspannungsableiter 10 wird elektrisch leitend. Die Fig. 2 zeigt den Zustand des Prüfkreises 1 ab dem Zeitpunkt T₃ bis zum Zeitpunkt T₄. Durch die Drosselspule 9 beginnt im Zeitpunkt T₃ der Strom i_{D} zu fliessen, wie ein Pfeil 18 andeutet, über der Drosselspule 9 fällt die Spannung u_{D} ab, wie ein Pfeil 19 andeutet, und am Überspannungsableiter 10 fällt die Spannung u_{Abl} ab, wie ein Pfeil 20 andeutet. Die Impedanz der Drosselspule 9 begrenzt den durch den Überspannungsableiter 10 fliessenden Strom und damit auch die Spannung u_{Abl}. Wenn die Spannung u_{Abl} und die Spannung u_{D} addiert werden, so erhält man, Verluste vernachlässigt, die Speisespannung u_{Sp}.

Aus der Fig. 4 ist zu ersehen, dass der Strom i_{c} als eingeprägter Strom zunächst unverändert weiter fliesst bis zum Zeitpunkt T₄, in welchem die Löschung des Lichtbogens 15 erfolgt. Dem Strom i_{c} überlagert sich ab dem Zeitpunkt T₃ jedoch der Strom i_{D}, der aus dieser Überlagerung sich ergebende Prüfstrom i_{Prüf} wird in der Phase etwas verschoben gegenüber dem Verlauf des Prüfstroms i_{Prüf} vor dem Zeitpunkt T₃ und geht zeitlich erst nach dem Strom i_{c} durch Null, und zwar im Zeitpunkt T₄. Der Prüfstrom i_{Prüf} wird im Zeitpunkt T₄ gelöscht, der Prüfkreis 1 ist damit unterbrochen, die in der Drosselspule 9 und in der Kondensatorbatterie 13 gespeicherte elektrische Energie schwingt dann anschliessend aus.

Nach dem Erlöschen des Lichtbogens 15 im Zeitpunkt T₄ fliesst der eingeprägte Strom i_{D} durch die Drosselspule 9 weiter bis zu seinem Nulldurchgang im Zeitpunkt T₅ und erlischt dort, ab dem Zeitpunkt T₅ sperrt der Überspannungsableiter 10 dann wieder. Der eingeprägte Strom i_{D} verhindert demnach ein Löschen des Überspannungsableiters 10 bis zum Zeitpunkt T₅. Der gleich grosse Strom i_{c} fliesst ebenfalls weiter bis zum Zeitpunkt T₅. und erlischt dort zwangsweise ebenfalls. Nach dem Erlöschen des Lichtbogens 15 im Zeitpunkt T₄ schwingt die Spannung u_{c} nicht mehr zusammen und etwa gleichphasig mit der Speisespannung u_{Sp}, sondern sie geht über auf den konstanten Spannungswert U₁.

Bei dem oben erwähnten Ausschwingen der gespeicherten elektrischen Energie wird die wiederkehrende Spannung u_{w} erzeugt, welche nach dem erfolgreichen Abschalten des Lichtbogens 15 die Strecke zwischen den Kontakten des Leistungsschalters 2 als Prüfspannung beaufschlagt. Diese wiederkehrende Spannung u_{w} wird in der Fig. 3 durch einen Pfeil 21 angedeutet. Die wiederkehrende Spannung u_{w} setzt sich zusammen aus der Speisespannung u_{Sp} und dem konstanten Spannungswert U₁, der von der geladenen Kondensatorbatterie 13 herrührt. Die Zeitspanne T_{TRV} bezeichnet die Zeit zwischen dem Zeitpunkt T₄ und dem Zeitpunkt T₆, wobei im Zeitpunkt T₆ der erste Scheitelwert der wiederkehrenden Spannung u_{w} auftritt.

Der Anstieg der wiederkehrenden Spannung u_{w} entspricht, wenn die Beschaltung des Prüfkreises 1 entsprechend den Anforderungen an eine 60 Hz-Prüfung ausgelegt ist, ziemlich genau der angestrebten (1-cosωt)-Kurve, in diesem Fall beträgt die Zeitspanne T_{TRV} 8,33 msec. Der Prüfkreis 1 ist jedoch, wenn die Prüfkreisparameter entsprechend angepasst werden, für beliebige andere Frequenzen modifizierbar.

Mit vergleichsweise einfachen Mitteln kann ein Generator 3 , der elektrische Energie im 50 Hz-Bereich liefert, als Energiequelle für die Prüfung des kapazitive Ausschaltvermögens von Schaltgeräten bei anderen Netzfrequenzen, insbesondere auch bei 60 Hz Netzfrequenz, eingesetzt werden. Auch ist es jetzt möglich, mit Hilfe des beschriebenen Prüfverfahrens beispielsweise die 60 Hz-Prüfung so realitätsnahe durchzuführen, dass in den Schaltgeräten keine unnötige Leistungsreserve vorgesehen werden muss, welche diese unerwünscht verteuern würde.

Eine Vereinfachung des Prüfkreises 1 ist möglich, wenn der Überspannungsableiter 10 thermisch so dimensioniert wird, dass er dem mehrfachen Ansprechen während einiger Perioden der Speisespannung u_{Sp} gewachsen ist. In diesem Fall kann das Einschaltgerät 11 entfallen. Der Überspannungsableiter 10 spricht dann vor dem eigentlichen Beginn des Ausschaltversuchs, also bereits vor der Öffnung des Leistungsschalters 2, in jeder Halbwelle der Speisespannung u_{Sp} und erlischt dann jeweils wieder. Die dann jeweils durch den Überspannungsabieiter 10 fliessenden Ströme sind eingeprägte Ströme, sodass es zu keiner grösseren Verzerrung der Strom- und Spannungsverläufe kommen kann. Die eigentliche Prüfung läuft dann genau gleich ab, wie bereits beschrieben. Durch den Wegfall des Einschaltgeräts 11 wird die Verfügbarkeit des Prüfkreises 1 vorteilhaft erhöht.

### BEZEICHNUNGSLISTE

- 1: Prüfkreis
- 2: Leistungsschalter
- 3: Generator
- 4: Transformator
- 5,5a: Pfeil
- 6: Klemme
- 7: Dämpfungswiderstand
- 8: Klemme
- 9: Drosselspule
- 10: Überspannungsableiter
- 11: Einschaltgerät
- 12: Klemme
- 13: Kondensatorbatterie
- 14: Klemme
- 15: Lichtbogen
- 16,17,18: Pfeil
- 19,20,21: Pfeil
- u_{Sp}: Speisespannung
- u_{C}: Spannung an der Kondensatorbatterie 13
- u_{D}: Spannung an der Drosselspule 9
- u_{Abl}: Spannung am Überspannungsableiter 10
- u_{w}: wiederkehrende Spannung
- U₁: Spannungswert
- i_{Prüf}: Prüfstrom
- i_{c}: Strom durch die Kondensatorbatterie 13
- i_{D}: Strom durch die Drosselspule 9
- T_{TRV}: Zeitspanne
- T₁,T₂, usw.: Zeitpunkte

## Patentansprüche

1. Prüfkreis (1) für die synthetische Prüfung des Abschaltens von kapazitiven Strömen bei einer von der Betriebsfrequenz der Energiequelle für die Speisung des Prüfkreises (1) abweichenden Frequenz, mit einem zu prüfenden Schaltgerät und einer zu diesem in Reihe geschalteten Kondensatorbatterie (13), dadurch gekennzeichnet,
- dass parallel zu der Kondensatorbatterie (13) ein zusätzlicher Schaltungszweig bestehend aus einer Reihenschaltung einer Drosselspule (9) mit einem Überspannungsableiter (10) geschaltet ist.

2. Prüfkreis nach Anspruch 1, dadurch gekennzeichnet,
- dass in dem zusätzlichen Schaltungszweig in Reihe zu der Drosselspule (9) und dem Überspannungsableiter (10) ein Einschaltgerät (11) geschaltet ist.

3. Prüfkreis nach Anspruch 2, dadurch gekennzeichnet,
- dass das Einschaltgerät (11) zeitgenau steuerbar ausgebildet ist, und
- dass das Einschaltgerät (11) stets vor einer Kontakttrennung des Schaltgeräts geschlossen wird.

4. Prüfkreis nach Anspruch 1 oder 2, dadurch gekennzeichnet,
- dass zu dem zu prüfenden Schaltgerät mindestens ein Dämpfungswiderstand (7) in Reihe geschaltet ist.
